Europäisches Patentamt

European Patent Office

Office européen des brevets

(19)

(11) Veröffentlichungsnummer: **0 276 725 B1**

(12) **EUROPÄISCHE PATENTSCHRIFT**

(45) Veröffentlichungstag der Patentschrift: **04.09.91**

(51) Int. Cl.5: **C25D 7/06**

(21) Anmeldenummer: **88100684.5**

(22) Anmeldetag: **19.01.88**

(54) Galvanisierungseinrichtung für plattenförmige Werkstücke, insbesondere Leiterplatten.

(30) Priorität: **26.01.87 DE 3702229**

(43) Veröffentlichungstag der Anmeldung:
**03.08.88 Patentblatt 88/31**

(45) Bekanntmachung des Hinweises auf die
Patenterteilung:
**04.09.91 Patentblatt 91/36**

(84) Benannte Vertragsstaaten:
**AT BE CH DE FR GB IT LI NL SE**

(56) Entgegenhaltungen:
**EP-A- 0 039 453**
**DE-A- 3 236 545**
**FR-A- 2 140 310**
**US-A- 3 535 222**
**US-A- 4 401 523**

(73) Patentinhaber: **Siemens Aktiengesellschaft**
**Wittelsbacherplatz 2**
**W-8000 München 2(DE)**

(72) Erfinder: **Hosten, Daniel**
**Staatsbaan 147**
**B-8120 Handzame(BE)**

Rank Xerox (UK) Business Services

EP 0 276 725 B1

## Beschreibung

Die Erfindung betrifft eine Galvanisiereinrichtung für im horizontalen Durchlauf zu behandelnde gelochte Leiterplatten, mit mindestens einer oberhalb und mindestens einer unterhalb der Durchlaufbahn parallel dazu angeordneten Anode.

Eine derartige Galvanisiereinrichtung ist aus der DE-A-32 36 545 bekannt. Bei der dort beschriebenen Einrichtung werden die plattenförmigen Werkstücke horizontal durch ein Elektrolytbad geführt. Der Vorschub der plattenförmigen Werkstücke erfolgt über angetriebene Kontakträder, die auf einer Seite im Bad angeordnet sind und gleichzeitig auch die kathodische Kontaktierung der Werkstücke übernehmen. Auf der den Kontakträdern gegenüberliegenden Seite ist zur Führung und Halterung der Werkstücke eine besondere Gleitbefestigung im Bad angeordnet. Bei den im Elektrolytbad angeordneten Anoden handelt es sich um lösliche Anodenstäbe, die quer zur Durchlaufbahn ausgerichtet und sowohl oberhalb als auch unterhalb der Durchlaufbahn angeordnet sind. Gemäß einer Variante können die oberen und unteren Anoden aber auch durch Titankörbe gebildet werden, die das lösliche Anodenmaterial in Form von Kugeln enthalten. In der Auffangwanne der Galvanisiereinrichtung sind oberhalb und unterhalb der Durchlaufbahn in Durchlaufrichtung ausgerichtete Düsenstöcke angeordnet, welchen die Elektrolytlösung aus einem Vorratsbehälter mittels einer Vielzahl von Tauchpumpen zugeführt wird. Die hohe Fließgeschwindigkeit der Elektrolytlösung durch die Düsenstöcke schafft neben dem Nachfüllen der Badzone auf das gewünschte Niveau auch eine gute Durchmischung der Elektrolytlösung, durch welche eine gleichförmige Zusammensetzung und gleichmäßige Stromdichten gewährleistet werden sollen. Zur Schaffung noch größerer Turbulenzen im Bad können die Düsenstöcke auch horizontal oder in Durchlaufrichtung hin- und herbewegt werden.

Aus der US-A-3 535 222 ist eine Einrichtung zum Reinigen und nachfolgenden Anodisieren von Aluminiumbändern bekannt. In der Anodisierstelle dieser Einrichtung sind zur Erzeugung von quer zur Durchlaufrichtung ausgerichteten Strömungen der Elektrolytlösung eingangsseitig obere und untere Auslaufstutzen und ausgangsseitig obere und untere Einlaufstutzen des Gehäuses vorgesehen.

Der Erfindung liegt die Aufgabe zugrunde, bei einer Galvanisiereinrichtung der eingangs genannten Art die Qualität der galvanisch abgeschiedenen Schichten weiter zu verbessern. Beim Durchkontaktieren und Galvanisieren der gelochten Leiterplatten sollten auch bei höheren Stromdichten stets hochwertige Kupferschichten mit einer guten Duktilität, einer hohen Haftfestigkeit und einer gleichmäßigen Schichtdickenverteilung abgeschieden werden können.

Diese Aufgabe wird bei einer gattungsgemäßen Galvanisiereinrichtung dadurch gelöst, daß einlaufseitig und auslaufseitig jeweils oberhalb und unterhalb der Durchlaufbahn quer dazu ausgerichtete Elektrolytsammler mit zwischen Durchlaufbahn und oberer bzw. unterer Anode gerichteten Öffnungen für den Zulauf und/oder Ablauf von Elektrolytlösung angeordnet sind und daß unterhalb der Durchlaufbahn mehrere quer dazu ausgerichtete, mit Elektrolytlösung beaufschlagbare Schwalldüsen zur Erzeugung von vertikal auf die Oberfläche der Leiterplatten gerichteten Strömungskomponenten angeordnet sind.

Der Erfindung liegt die Erkenntnis zugrunde, daß qualitativ hochwertige Oberflächen der galvanisch abgeschiedenen Schichten nur durch in Durchlaufrichtung der Werkstücke gerichtete Strömungskomponenten der Elektrolytflüssigkeit gewährleistet werden können und daß derartige Strömungskomponenten in Längsrichtung durch die erfindungsgemäße Anordnung der Elektrolytsammler realisiert werden können. Für die Herstellung von Durchkontaktierungen in den gelochten Leiterplatten sind jedoch zusätzlich noch vertikale Strömungskomponenten der Elektrolytlösung erforderlich, die durch quer zur Durchlaufbahn ausgerichtete Schwalldüsen erzeugt werden.

Die Strömungskomponenten in Längsrichtung können sowohl durch den Zulauf als auch den Ablauf von Elektrolytlösungen durch die Öffnungen der Elektrolytsammler erzeugt werden. Besonders günstige Ergebnisse werden jedoch erzielt, wenn mindestens ein Elektrolytsammler für den Zulauf von Elektrolytlösungen bestimmt ist.

Gemäß einer bevorzugten Ausgestaltung der Erfindung sind zwei Elektrolytsammler für den Zulauf und zwei Elektrolytsammler für den Ablauf von Elektrolytlösung bestimmt. Eine weitere Verbesserung der Qualität der galvanisch abgeschiedenen Schichten kann in diesem Fall dann erzielt werden, wenn die beiden auslaufseitig angeordneten Elektrolytsammler für den Zulauf von Elektrolytlösung bestimmt sind. Dies bedeutet mit anderen Worten, daß hier die Strömungskomponente in Längsrichtung der Durchlaufrichtung der Werkstücke entgegengesetzt ist.

Weiterhin hat es sich insbesondere für eine gute Durchflutung der Löcher in Leiterplatten als sehr günstig erwiesen, wenn die Elektrolytlösung der beiden für den Zulauf bestimmten Elektrolytsammler über separate Pumpen zuführbar ist. Eine besonders effektive Durchflutung der Löcher kann dadurch erzielt werden, daß dem oberhalb der Durchlaufbahn angeordneten Elektrolytsammler eine größere Menge an Elektrolytlösung zugeführt wird, als dem unterhalb der Durchlaufbahn angeordneten Elektrolytsammler.

2

Gemäß einer weiteren Ausgestaltung der Erfindung ist vorgesehen, daß die Öffnungen unter einem geringen Anstellwinkel schräg auf die Durchlaufbahn gerichtet sind. Durch diese konstruktiv einfach zu realisierende Maßnahme kann dann die Aus- oder Eintrittsmündung der Öffnungen sehr dicht an die Oberfläche der durchlaufenden Werkstücke herangebracht werden.

Es hat sich auch als vorteilhaft erwiesen, wenn die Öffnungen in Form von gleichmäßig über die Breite der Durchlaufbahn angeordneten Bohrungen in die Elektrolytsammler eingebracht sind. Deratige Öffnungen ermöglichen bei einem gegenüber in Querrichtung durchgehenden Schlitzen geringeren konstruktiven Aufwand eine gleichmäßigere Verteilung der erwünschten Strömungskomponente.

Gemäß einer weiteren Ausgestaltung der Erfindung sind die Schwalldüsen unterhalb der sieb- oder gitterförmig ausgebildeten, unlöslichen unteren Anode angeordnet. Hierdurch wird die Unterbringung der Schwalldüsen im Elektrolytbad erheblich erleichtert. Die Schwalldüsen sind dann vorzugsweise als Schlitzrohre ausgebildet, die sich hier für die Durchflutung günstiger als Bohrungen erwiesen haben. Sind die Schwalldüsen über eine separate Pumpe mit Elektrolytlösung beaufschlagbar, so können die Bedingungen der Elektrolytbewegung insgesamt noch besser optimiert und auf die jeweiligen Besonderheiten der zu behandelnden Werkstücke abgestimmt werden.

Schließlich hat es sich auch als besonders günstig herausgestellt, wenn die obere Anode als lösliche Anode mit auf einem sieb- oder gitterförmigen Träger angeordneten, löslichen Anodenmaterial ausgebildet ist. Es werden also die Vorteile einer löslichen Anode erzielt, wobei gleichzeitig ein gleichbleibender Abstand zu den durchlaufenden Werkstücken gewährleistet ist. Insbesondere durch die Kombination einer derartigen oberen Anode mit einer unlöslichen unteren Anode werden im Hinblick auf die Streuung der Schichtdicken und die Schichtdickenverteilung auf der Oberfläche der Werkstücke optimale Bedingungen bei einfacher Wartung der Galvanisiereinrichtung erreicht.

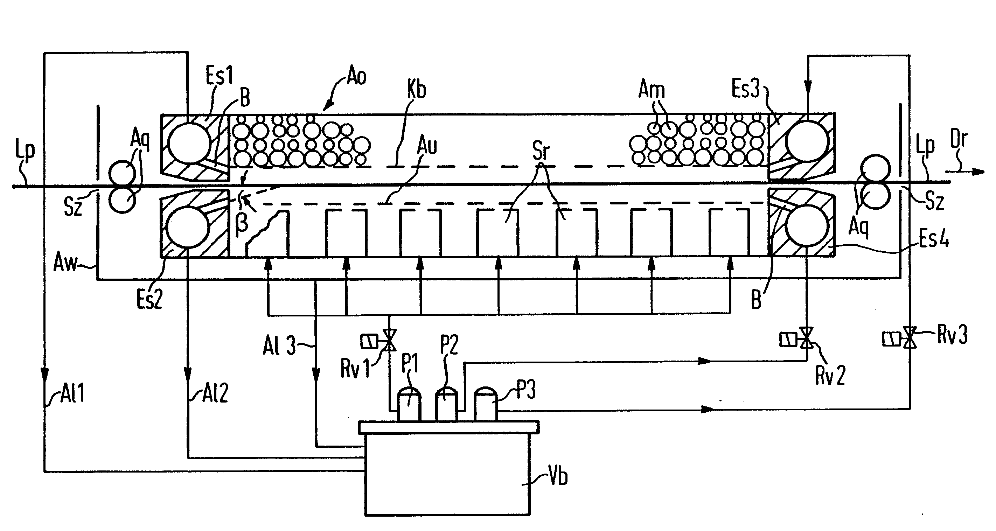

Ein Ausführungsbeispiel der Erfindung ist in der Zeichnung dargestellt und wird im folgenden näher beschrieben.

Die Zeichnung zeigt in stark vereinfachter schematischer Darstellung die Galvanisiereinrichtung einer Horizontal-Durchlaufanlage zum Durchkontaktieren und Galvanisieren von Leiterplatten. Die einzelnen zu galvanisierenden gelochten Leiterplatten Lp werden nacheinander auf einer horizontalen Durchlaufbahn durch eine nicht näher dargestellte Elektrolytlösung geführt, die sich in einer mit Aw bezeichneten Auffangwanne befindet. In Durchlaufrichtung Dr gesehen werden die Leiterplatten Lp durch einen horizontalen einlaufseitigen Schlitz Sz der Auffangwanne Aw zwei einlaufseitigen Abquetschwalzen Aq zugeführt, dann mit Hilfe von nicht näher dargestellten Transportmitteln zwischen einer oberen Anode Ao und einer unteren Anode Au durch die Elektrolytlösung transportiert bis sie die Galvanisiereinrichtung dann wieder über auslaufseitige Abquetschwalzen Aq und einen horizontalen auslaufseitigen Schlitz Sz der Auffangwanne Aw wieder verlassen. Zumindest im Bereich zwischen der oberen Anode Ao und der unteren Anode Au werden die einzelnen Leiterplatten Lp über ebenfalls nicht näher dargestellte Kontaktiereinrichtungen kathodisch kontaktiert. Bei der im geringen Abstand über der Durchlaufbahn der Leiterplatten Lp horizontal angeordneten oberen Anode Ao handelt es sich um eine lösliche Anode, die aus einem Korb Kb und darin in einer Lage oder in mehreren Lagen angeordnetem Anodenmaterial Am besteht. Der aus Streckmetall gebildete Boden des insgesamt aus Titan bestehenden Korbes Kb bildet einen für die Elektrolytlösung leicht durchlässigen Träger für das Anodenmaterial Am. Im vorliegenden Fall handelt es sich bei der Elektrolytlösung um ein Kupferbad und bei dem Anodenmaterial Am um Kupferkugeln die häufig auch als Cu-Pellets bezeichnet werden. Die horizontal ausgerichtete untere Anode Au ist als unlösliche Anode ausgebildet und in geringem Abstand unter der Durchlaufbahn der Leiterplatten Lp angeordnet. Durch die Ausbildung als Streckmetallsieb aus platiniertem Titan wird auch hier eine Behinderung des Elektrolytaustausches und der Strömung der Elektrolytlösung ausgeschlossen. Im übrigen hat die dargestellte Kombination aus löslicher oberer Anode Ao und unlöslicher unterer Anode Au den Vorteil, daß der Abstand zu den dazwischen durchlaufenden Leiterplatten Lp konstant bleibt und somit im Hinblick auf die Streuung der Schichtdicke und die Schichtdickenverteilung auf der Oberfläche optimale Bedingungen erreicht werden.

Um beim galvanischen Aufbau der Leiterbahnen und Durchkontaktierungen der Leiterplatten Lp eine Abscheidung glänzender Kupferschichten zu gewährleisten werden an die Elektrolytbewegung besondere Anforderungen gestellt. Hierzu sind im Bereich unter der unteren Anode Au mehrere quer zur Durchlaufbahn ausgerichtete Schlitzrohre Sr angeordnet, die aus einem Vorratsbehälter Vb über eine Pumpe P1 mit Elektrolytlösung beaufschlagt werden, wobei die Menge über ein Regelventil Rv1 variiert werden kann. Die Schlitze der Schlitzrohre Sr sind dabei so ausgerichtet, daß die Leiterplatten Lp im wesentlichen in vertikaler Richtung von unten her angeströmt werden.

Da die Schlitzrohre Sr allein noch nicht die Abscheidung glänzender Kupferschichten gewährleisten sind zusätzlich noch einlaufseitig und auslaufseitig jeweils oberhalb und unterhalb der Durchlaufbahn quer dazu ausgerichtete Elektrolytsammler Es1, Es2, Es3 und Es4 vorgesehen. Jeder dieser Elektrolytsammler

EP 0 276 725 B1

Es1 bis Es4 besitzt mehrere gleichmäßig über die Breite der Durchlaufbahn angeordnete Bohrungen B, die unter einem geringen Anstellwinkel $\beta$ von beispielsweise 10° schräg auf die Durchlaufbahn und in den spaltförmigen Bereich zwischen Durchlaufbahn und oberer Anode Ao bzw. unterer Anode, Au gerichtet sind.

Der auslaufseitig unterhalb der Durchlaufbahn angeordnete Elektrolytsammler Es4 wird über eine Pumpe P2 aus dem Vorratsbehälter Vb mit Elektrolytlösung beaufschlagt, wobei die Menge über ein Regelventil Rv2 variiert werden kann. Aus den Bohrungen B des Elektrolytsammlers Es4 tritt die zugeführte Elektrolytlösung dann mit einer im wesentlichen horizontalen Geschwindigkeitskomponente aus, die auf der Unterseite der Leiterplatten Lp verläuft und der Durchlaufrichtung Dr entgegengesetzt ist.

Der auslaufseitig oberhalb der Durchlaufbahn angeordnete Elektrolytsammler Es3 wird über eine Pumpe P3 aus dem Vorratsbehälter Vb mit Elektrolytlösung beaufschlagt, wobei die Menge über ein Regelventil Rv3 variiert werden kann. Aus den Bohrungen B des Elektrolytsammlers Es3 tritt die zugeführte Elektrolytlösung dann mit einer im wesentlichen horizontalen Geschwindigkeitskomponente aus, die auf der Oberseite der Leiterplatten Lp verläuft und der Durchlaufrichtung Dr entgegengesetzt ist.

Die horizontalen Geschwindigkeitskomponenten der Elektrolytströmung an der Oberseite und Unterseite der Leiterplatten Lp werden durch die einlaufseitigen Elektrolytsammler Es1 bzw. Es2 weiter begünstigt, da diese für den Ablauf von Elektrolytlösung bestimmt sind und über Ablauf-Leitungen AL1 bzw. AL2 mit dem Vorratsbehälter Vb verbunden sind. Zur weiteren Verbesserung der Elektrolytumwälzung ist auch die Auffangwanne Aw über eine Ablauf-Leitung AL3 mit dem Vorratsbehälter Vb verbunden.

Bei dem vorstehend erläuteren Ausführungsbeispiel wird eine Elektrolytbewegung mit einer sehr guten Durchflutung der Löcher der Leiterplatten Lp und einer starken Elektrolytströmung entlang der Leiterplattenoberfläche erzielt. Dabei wurden folgende Parameter eingestellt:

```
Durchlaufpumpe Pumpe P1 :          5000 l/h
Austrittsgeschwindigkeit:          3,6 m/sec


Durchlaufpumpe Pumpe P2 :          8000 l/h
Austrittsgeschwindigkeit:          4,1 m/sec


Durchlaufpumpe Pumpe P3 :          12000 l/h
Austrittsgeschwindigkeit:          6,2 m/sec
```

Das beschriebene Ausführungsbeispiel stellt lediglich eine bevorzugte erste Möglichkeit für die Elektrolytbewegung mit Hilfe der Elektrolytsammler Es1 bis Es4 und der Schlitzrohre Sr dar. Weitere Möglichkeiten, die jedoch noch keine anschließende Aufzählung darstellen sollen, gehen aus der nachfolgenden Tabelle hervor.

| | Es1 | Es2 | Es3 | Es4 | Sr |
|---|---|---|---|---|---|
| 1. Möglichkeit | Ablauf | Ablauf | Zulauf | Zulauf | Zulauf |
| 2. Möglichkeit | Zulauf | Zulauf | Ablauf | Ablauf | Zulauf |
| 3. Möglichkeit | Ablauf | Zulauf | Ablauf | Zulauf | Zulauf |
| 4. Möglichkeit | Zulauf | Ablauf | Ablauf | Zulauf | Zulauf |

Es ist zu erkennen, daß die erfindungsgemäße Anordnung der Elektrolytsammler eine breitgefächerte

4

Beeinflussung der Elektrolytlösung und eine flexible Anpassung an die jeweils zu galvanisierenden Werkstücke ermöglicht.

**Patentansprüche**

1. Galvanisierungseinrichtung für im horizontalen Durchlauf zu behandelnde gelochte Leiterplatten (Lp), mit mindestens einer oberhalb und mindestens einer unterhalb der Durchlaufbahn parallel dazu angeordneten Anode (Ao, Au),
**dadurch gekennzeichnet,**
daß einlaufseitig und auslaufseitig jeweils oberhalb und unterhalb der Durchlaufbahn quer dazu ausgerichtete Elektrolytsammler (Es1, Es2, Es3, Es4) mit zwischen Durchlaufbahn und oberer bzw. unterer Anode (Ao, Au) gerichteten Öffnungen für den Zulauf und/oder Ablauf von Elektrolytlösung angeordnet sind und daß unterhalb der Durchlaufbahn mehrere quer dazu ausgerichtete, mit Elektrolytlösung beaufschlagbare Schwalldüsen zur Erzeugung von vertikal auf die Oberfläche der Leiterplatten (Lp) gerichteten Strömungskomponenten angeordnet sind.

2. Galvanisierungseinrichtung nach Anspruch 1,
**dadurch gekennzeichnet,**
daß mindestens ein Elektrolytsammler für den Zulauf von Elektrolytlösung bestimmt ist.

3. Galvanisierungseinrichtung nach Anspruch 2,
**dadurch gekennzeichnet,**
daß zwei Elektrolytsammler für den Zulauf und zwei Elektrolytsammler für den Ablauf von Elektrolytlösung bestimmt sind.

4. Galvanisierungseinrichtung nach Anspruch 3,
**dadurch gekennzeichnet,**
daß die beiden auslaufseitig angeordneten Elektrolytsammler (Es3, Es4) für den Zulauf von Elektrolytlösung bestimmt sind.

5. Galvanisierungseinrichtung nach Anspruch 3 oder 4,
**dadurch gekennzeichnet,**
daß die Elektrolytlösung den beiden für den Zulauf bestimmten Elektrolytsammlern (Es3, Es4) über separate Pumpen (P2, P3) zuführbar ist.

6. Galvanisierungseinrichtung nach Anspruch 3, 4 oder 5,
**dadurch gekennzeichnet,**
daß dem oberhalb der Durchlaufbahn angeordneten Elektrolytsammler (Es3) eine größere Menge an Elektrolytlösung zuführbar ist als dem unterhalb der Durchlaufbahn angeordneten Elektrolytsammer (Es4).

7. Galvanisierungseinrichtung nach einem der vorhergehenden Ansprüche,
**dadurch gekennzeichnet,**
daß die Öffnungen unter einem geringen Anstellwinkel (β) schräg auf die Durchlaufbahn gerichtet sind.

8. Galvanisierungseinrichtung nach einem der vorhergehenden Ansprüche,
**dadurch gekennzeichnet,**
daß die Öffnungen in Form von gleichmäßig über die Breite der Durchlaufbahn angeordneten Bohrungen (B) in die Elektrolytsammler (Es1, Es2, Es3, Es4) eingebracht sind.

9. Galvanisierungseinrichtung nach einem der vorhergehenden Ansprüche,
**dadurch gekennzeichnet,**
daß die Schwalldüsen unterhalb der sieb- oder gitterförmig ausgebildeten, unlöslichen unteren Anode (Au) angeordnet sind.

10. Galvanisierungseinrichtung nach Anspruch 9,
**dadurch gekennzeichnet,**
daß die Schwalldüsen als Schlitzrohre (Sr) ausgebildet sind.

**11.** Galvanisierungseinrichtung nach Anspruch 9 oder 10,
**dadurch gekennzeichnet,**
daß die Schwalldüsen über eine separate Pumpe (P1) mit Elektrolytlösung beaufschlagbar sind.

**12.** Galvanisierungseinrichtung nach einem der vorhergehenden Ansprüche,
**dadurch gekennzeichnet,**
daß die obere Anode (Ao) als lösliche Anode mit auf einem sieb- oder gitterförmigen Träger angeordnetem, löslichen Anodenmaterial (Am) ausgebildet ist.

**Claims**

1. Electroplating apparatus for perforated printed circuit boards (Lp) to be treated in a horizontal through-put path, having at least one anode (Ao) arranged above and at least one anode (Au) arranged below the through-put path parallel therewith, characterised in that electrolyte headers (Es1, Es2, Es3, Es4) having openings for the inflow and/or outflow of electrolytic solution which are directed between the through-put path and the upper or lower anode (Ao, Au) are arranged on the input side and on the discharge side above and below the through-put path and transversely thereto in each case, and in that below the through-put path a plurality of wash nozzles aligned transversely thereto and which can be pressurised with electrolytic solution are arranged for the purpose of generating flow components directed vertically onto the surface of the printed circuit boards (Lp).

2. Electroplating apparatus according to Claim 1, characterised in that at least one electrolyte header is provided for the inflow of electrolytic solution.

3. Electroplating apparatus according to Claim 2, characterised in that two electrolyte headers are provided for the inflow, and two electrolyte headers are provided for the outflow of electrolytic solution.

4. Electroplating apparatus according to Claim 3, characterised in that the two electrolyte headers (Es3, Es4) arranged on the discharge side are provided for the inflow of electrolytic solution.

5. Electroplating apparatus according to Claim 3 or 4, characterised in that the electrolytic solution can be supplied via separate pumps (P2, P3) to the two electrolyte headers (Es3, Es4) provided for the inflow.

6. Electroplating apparatus according to Claim 3, 4 or 5, characterised in that a greater quantity of electrolytic solution can be supplied to the electrolyte header (Es3) arranged above the throughput path than to the electrolyte header (Es4) arranged below the through-put path.

7. Electroplating apparatus according to one of the preceding claims, characterised in that the openings are obliquely directed at the throughput path at a slight attack angle ($\beta$).

8. Electroplating apparatus according to one of the preceding claims, characterised in that the openings are introduced into the electrolyte headers (Es1, Es2, Es3, Es4) in the form of bores (B) arranged uniformly over the width of the through-put path.

9. Electroplating apparatus according to one of the preceding claims, characterised in that the wash nozzles are arranged below the insoluble lower anode (Au), which is constructed in the shape of a sieve or grating.

10. Electroplating apparatus according to Claim 9, characterised in that the wash nozzles are constructed as slotted tubes (Sr).

11. Electroplating apparatus according to Claim 9 or 10, characterised in that the wash nozzles can be pressurised with electrolytic solution via a separate pump (P1).

12. Electroplating apparatus according to one of the preceding claims, characterised in that the upper anode (Ao) is constructed as a soluble anode using soluble anode material (Am) arranged on a sieve-shaped or grating-shaped carrier.

**Revendications**

1. Dispositif de galvanisation pour des plaquettes à circuits imprimés perforées (Lp), qui doivent être traitées lors de leur transfert horizontal, et comportant au moins une anode (Ao) disposée au-dessus et au moins une anode (Au) disposée au-dessous de la voie de transfert, parallèlement à cette dernière, caractérisé par le fait que sur le côté entrée et sur le côté sortie et respectivement au-dessus et au-dessous de la voie de transfert sont prévus des dispositifs (Es1,Es2,Es3,Es4) de collecte de l'électrolyte, qui sont orientés transversalement par rapport à la voie de transfert et qui comportent des ouvertures orientées entre la voie de transfert et l'anode supérieure ou l'anode inférieure (Ao,Au), pour l'amenée et/ou l'évacuation de la solution d'électrolyte, et qu'au-dessous de la voie de transfert sont disposées plusieurs buses de projection qui sont orientées transversalement par rapport à la voie de transfert, qui sont chargées par la solution d'électrolyte et qui servent à produire des composantes d'écoulement dirigées verticalement sur la surface des plaquettes à circuits imprimés (Lp).

2. Dispositif de galvanisation suivant la revendication 1, caractérisé par le fait qu'au moins un dispositif de collecte de l'électrolyte est prévu pour l'amenée de la solution d'électrolyte.

3. Dispositif de galvanisation suivant la revendication 2, caractérisé par le fait que deux dispositifs de collecte de l'électrolyte sont prévus pour l'amenée de la solution d'électrolyte et que deux dispositifs de collecte de l'électolyte sont prévus pour l'évacuation de la solution de l'électrolyte

4. Dispositif de galvanisation suivant la revendication 3, caractérisé par le fait que les deux dispositifs (Es3,Es4) de collecte de l'électrolyte, situés côté sortie, sont prévus pour l'amenée de la solution d'électrolyte.

5. Dispositif de galvanisation suivant la revendication 3 ou 4, caractérisé par le fait que la solution d'électrolyte peut être envoyée aux deux dispositifs (Es3, Es4) de collecte de l'électrolyte, prévus pour l'amenée, par l'intermédiaire de pompes séparées (P2,P3).

6. Dispositif de galvanisation suivant la revendication 3, 4 ou 5, caractérisé par le fait qu'une quantité plus importante de la solution d'électrolyte peut être envoyée au dispositif (Es3) de collecte de l'électrolyte, disposé au-dessus de la voie de transfert, au dispositif (Es4) de collecte de l'électrolyte, disposé au-dessous de la voie de transfert.

7. Dispositif de galvanisation suivant l'une des revendications précédentes, caractérisé par le fait que les ouvertures sont orientées obliquement par rapport à la voie de transfert, sous un faible angle d'incidence ($\beta$).

8. Dispositif de galvanisation suivant l'une des revendications précédentes, caractérisé par le fait que les ouvertures sont ménagées, sous la forme de perçages (B) disposés régulièrement sur toute la largeur de la voie de transfert, dans les dispositifs (Es1,Es2,Es3,Es4) de collecte de l'électrolyte.

9. Dispositif de galvanisation suivant l'une des revendications précédentes, caractérisé par le fait que les buses de projection sont disposées au-dessous de l'anode inférieure insoluble (Au) réalisée sous la forme d'un tamis ou d'une grille.

10. Dispositif de galvanisation suivant la revendication 9, caractérisé par le fait que les buses de projection sont réalisées sous la forme de tubes fendus (Sr).

11. Dispositif de galvanisation suivant la revendication 9 ou 10, caractérisé par le fait que les buses de projection peuvent être chargées avec la solution d'électrolyte, par l'intermédiaire d'une pompe séparée (P1).

12. Dispositif de galvanisation suivant l'une des revendications précédentes, caractérisé par le fait que l'anode supérieure (Au) est réalisée sous la forme d'une anode soluble constituée par un matériau soluble (Am) disposé sur un support en forme de tamis ou de grille.

7

EP 0 276 725 B1